# EUROPÄISCHE PATENTSCHRIFT

(11) **EP 0 721 667 B1**
(45) Veröffentlichungstag und Bekanntmachung des Hinweises auf die Patenterteilung: **29.11.2006**
(21) Anmeldenummer: 94928257.8
(22) Anmeldetag: 28.09.1994
(51) Int. Cl.: H01L 31/0336, H01L 31/032, H01L 31/0224

(54) **SOLARZELLE MIT EINER CHALKOPYRITABSORBERSCHICHT**
SOLAR CELL WITH A CHALCOPYRITE ABSORBER LAYER
CELLULE SOLAIRE AVEC UNE COUCHE D'ABSORPTION EN CHALCOPYRITE

(30) Priorität: 30.09.1993 DE 4333407
(43) Veröffentlichungstag der Anmeldung: 17.07.1996
(73) Patentinhaber: Shell Solar GmbH, 81739 München (DE)
(72) Erfinder: PROBST, Volker, D-81547 München (DE); KARG, Franz, D-81671 München (DE)
(74) Vertreter: Zeestraten, Albertus W. J.
(86) Internationale Anmeldenummer: PCT/DE1994/001125
(87) Internationale Veröffentlichungsnummer: WO 1995/009441

(56) Entgegenhaltungen:
- EP-A- 0 360 403
- WO-A-90/15445
- US-A- 4 536 607
- US-A- 4 642 140
- SOLAR ENERGY MATERIALS, Bd.23, Nr.1, November 1991, AMSTERDAM NL Seiten 31 - 45 C. GUILLEN ET AL. 'Optical properties of electrochemically deposited CuInSe2 thin films'
- PATENT ABSTRACTS OF JAPAN vol. 18, no. 120 (E-1516) 25. Februar 1994 & JP,A,05 315 633 (DOWA MINING CO. LTD.) 26. November 1993

## Beschreibung

Ein Hauptziel in der Photovoltaik ist die Entwicklung von möglichst langzeitstabilen und hoch effizienten Solarzellen bei gleichzeitig niedrigen Herstellungskosten. Nur dann wird diese Form der Energieerzeugung gegen andere konventionelle Verfahren konkurrenzfähig.

Bezüglich Wirkungsgrad und Langzeitstabilität gelten derzeit Solarmodule aus einkristallinem Silizium als Standard. Wegen hoher Herstellungskosten und langer Energierücklaufzeiten, d. h. Zeitdauern, innerhalb der die zur Herstellung eingesetzte Energie durch photovoltaische Stromerzeugung ausgeglichen ist, ist der Solarstrom aus solchen Standardmodulen noch nicht an der Schwelle zur Konkurrenzfähigkeit angelangt.

Erfolgversprechende Ansätze zur Herstellung kostengünstiger und langzeitstabiler Solarzellen werden derzeit bei Solarzellen aus polykristallinen I-III-VI₂-Chalkopyrit-Halbleitern vermutet. Insbesondere das CuInSe₂ (CIS) und verwandte Legierungen sind Materialien, die einen hohen Absorptionskoeffizienten, einen direkten Bandübergang und einen, dem Sonnenspektrum angepaßten Bandabstand aufweisen. Sie lassen sich in kostengünstigen Dünnschichtabscheideverfahren herstellen und haben in Laborversuchen bereits Wirkungsgrade von fast 17 % erreicht.

Eine aus der US 5 141 564 bekannte Zellenstruktur besteht aus einem Glassubstrat, einer Molybdän-Rückelektrode, einer 1 bis 5 µm dicken Absorberschicht aus polykristallinem ChalkopyritHalbleiter der Zusammensetzung CuInGaSe₂ oder CuIn(S,Se)₂, einer dünnen Cadmiumsulfidfensterschicht und einer transparenten Frontelektrode.

Nachteilig an CIS-Solarzellen sind bislang die schlechte Haftung der Absorberschicht auf der Molybdän-Rückelektrode und die geringe Reproduzierbarkeit, die in dem komplizierten Herstellungsprozeß für den ternären Halbleiter begründet ist.

Zur Herstellung werden entweder die Komponenten in elementarer Form nacheinander oder zusammen über dem Substrat aufgebracht und durch Einstellen geeigneter Reaktionsbedingungen miteinander zur Reaktion gebracht (2-Stufen-Prozeß). Möglich ist es auch, nur die beiden metallischen Komponenten aufzubringen und den nichtmetallischen Reaktionspartner über eine entsprechend reaktive Atmosphäre bereitzustellen. Eine weitere Möglichkeit besteht darin, die Ausgangskomponenten in elementarer Form auf ein vorgeheiztes Substrat aufzudampfen, wobei die Reaktion zum ternären Halbleiter unmittelbar vor oder nach dem Auftreffen auf dem Substrat erfolgt. Dieser einstufige Prozeß läßt sich jedoch nur schwierig als großflächiger Abscheideprozeß durchführen, da eine Schichtgleichmäßigkeit bei größeren Flächen nicht gewährleistet werden kann.

Besonders beim Zweistufenprozeß wird eine Ablösung der Absorberschicht von der Molybdän-Rückelektrode beobachtet, die bereits bei der Herstellung der Solarzellen zu einer Reihe nicht funktionsfähiger oder leistungsverminderter Solarzellen führt. Weitere Schädigungen durch Schichtablösung können beim späteren Betrieb der Solarzellen infolge von Temperaturwechselbelastungen im Tag/Nacht- oder Jahreszeitenwechsel beobachtet werden.

Aus der US 4 915 745 ist bekannt, eine Zwischenschicht aus Ga als Haftvermittler zwischen einer Molybdän-Rückelektrode und einer CIS-Schicht einzusetzen. Damit wird zwar die Haftung der Absorberschicht auf der Rückelektrode verbessert, doch wird gleichzeitig die Homogenität der Schichten verringert.

Aus der WO 90/15 445 A1 ist eine Zwischenschicht aus Tellur bekannt, die die Haftung zwischen Molybdän-Rückelektrode und Absorberschicht verbessern soll. Nachteilig an diesem Verfahren ist ebenso wie in der genannten US4 915 745 die Einführung eines neuen und im Fall des Tellur auch toxischen Materials in den Schichtaufbau der CIS-Solarzelle. Dies erhöht die Komplexität der Abscheidungen und damit den Aufwand bei der Herstellung. Zusätzlich entstehen Probleme bei der Entsorgung nicht mehr funktionstüchtiger Solarzellen.

Aufgabe der vorliegenden Erfindung ist es daher, eine Solarzelle mit verbesserter Haftung zwischen Substrat und Absorberschicht anzugeben, die keine zusätzlichen toxischen Materialien enthält, und deren Herstellungsaufwand gegenüber bekannten Verfahren nicht oder nicht wesentlich erhöht ist.

Diese Aufgabe wird erfindungsgemäß durch eine Solarzelle mit den Merkmalen von Anspruch 1 gelöst. Weitere Ausgestaltungen der Erfindung sind den Unteransprüchen zu entnehmen.

Wie auch bei den beiden letztgenannten Schriften wird zur Lösung der Haftungsprobleme der Absorberschicht auf der Rückelektrode ein Haftvermittler eingeführt. Dieser ist entweder ausgewählt aus den reaktiven Metallen Chrom, Titan oder Tantal oder besteht aus einer Titannitrid-Schicht. Die Herstellung dieser Haftvermittlerschichten ist mit dem vorhandenen und gebräuchlichen Anlagen in einfacher Weise möglich und läßt sich gut in einen konventionellen Herstellungsprozeß für die Chalkopyrit-Solarzellen integrieren.

Als bevorzugtes Material zur Haftvermittlung wird Chrom verwendet, welches zu einer sehr guten Haftung der Chalkopyrit-Absorberschicht führt. Außerdem wird mit Chrom die Ausbeute funktionsfähiger Solarzellen im Herstellungsverfahren erhöht und die Leistung bzw. der Wirkungsgrad der damit gefertigten Solarzellen verbessert. Weiterhin wurde Chrom schon bereits bei bekannten Verfahren im Schichtaufbau als Haftschicht zwischen Substrat- und Molybdän-Rückelektrode verwendet. Somit ist die Einführung eines neuen Materials in den Schichtaufbau nicht nötig und es kann die bereits vorhandene Anlage und dieselbe Technik verwendet werden.

Doch auch die anderen vorgeschlagenen reaktiven Metalle Titan und Tantal sind als Haftvermittler wirksam und lassen sich problemlos einsetzen.

Möglich ist es auch, eines der reaktiven Metall Chrom, Titan oder Tantal als haftvermittelnde Zwischenschicht zwischen der Absorberschicht und der Molybdän-Rückelektrode aufzubringen. Dabei sind Schichtdicken von 1nm an ausreichend und solche von 10 bis 40 nm bevorzugt. Mit dieser Zwischenschicht wird verhindert, daß die Halbleiterkomponente Selen bei der Bildung der Absorberschicht mit der Molybdän-Rückelektrode zu einem Molybdän-Selenid reagiert. In diesen Molybdän-Seleniden wird bei bekannten Verfahren die Ursache für die Haftungsprobleme gesehen, da Molybdän-Selenid ebenso wie MolybdänSulfid ein bekanntes Gleit- und Schmiermittel darstellt.

In einer weiteren Ausgestaltung der Erfindung wird vorgeschlagen, eine haftvermittelnde Schicht aus Titannitrid über einer aus Titan bestehenden Rückelektrode vorzusehen. Diese bisher nur aus der Mikroelektronik bekannte und dort zur Herstellung von Kontakten verwendete Materialkombination ist ebenfalls in hervorragender Weise zur Verbesserung der Haftung der Absorberschicht auf dem Substrat geeignet.

Zur Herstellung der Schichtkombination ist nur eine einzige Anlage erforderlich, da beide Schichten in der gleichen Anlage erzeugt werden können. Wird beispielsweise ein Sputterverfahren zum Aufbringen der Titanschicht verwendet, so kann durch Beimischen von Stickstoff oder stickstoffhaltigen Verbindungen zur Sputteratmosphäre in einfacher Weise zur Abscheidung von Titannitrid übergegangen werden.

Im folgenden wird die Erfindung anhand von Ausführungsbeispielen und der dazugehörigen zwei Figuren näher erläutert.

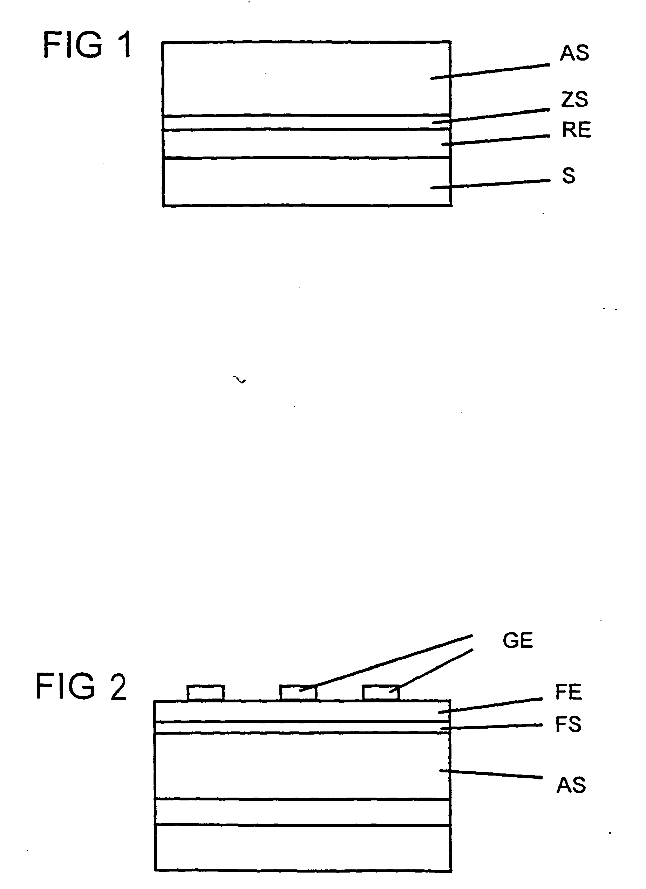

Figur 1 zeigt ausschnittsweise einen erfindungsgemäßen Aufbau im schematischen Querschnitt, während Figur 2 den möglichen Aufbau einer kompletten Solarzelle im schematischen Querschnitt zeigt.

### Erstes Ausführungsbeispiel:

Figur 1: Als Substrat S dient üblicherweise eine Glasplatte aus Fensterglas. Möglich ist es auch, das Substrat S aus beliebigen elektrisch nichtleitenden oder leitenden Materialien herzustellen. Wird Fensterglas (Natronkalkglas) verwendet, so kann dieses mit einer weiteren Haftschicht versehen werden, beispielsweise mit einer dünnen aufgesputterten Chromschicht (in der Figur nicht dargestellt).

Auf das Substrat S wird nun die Rückelektrode RE aufgebracht, beispielsweise durch Aufsputtern einer ca. 1 µm dicken Molybdänschicht. Auf diesen insoweit bereits bekannten Aufbau wird nun eine dünne haftvermittelnde Zwischenschicht ZS aufgebracht. Dazu sind gängige Dünnfilm - Beschichtungsverfahren geeignet, beispielsweise Aufdampfen, galvanische Abscheidung oder vorzugsweise Aufsputtern. Als Material für die Zwischenschicht wird Chrom, Titan oder Tantal gewählt. Die Zwischenschicht ist bereits in einer Dicke ab ca. 1 nm wirksam und wird vorzugsweise in einer Dicke von 5 bis 40 nm aufgebracht. Auf das mit Rückelektrode RE und Zwischenschicht ZS versehene Substrat S wird nun mit einem gängigen Dünnfilmbeschichtungsverfahren eine Absorberschicht AS aufgebracht. Mit geeigneten Verfahren, wie beispielsweise Sputtern, Aufdampfen oder galvanische Abscheidung kann so ein aus elementaren Einzelschichten der Ausgangskomponenten des Verbundhalbleiters bestehender Schichtaufbau abgeschieden werden. Z. B. werden dazu Einzelschichten aus Kupfer, Indium und Selen in jeweils einer solchen Dicke erzeugt, daß der Verbindungshalbleiter der Absorberschicht AS die gewünschte Stöchiometrie und Dicke erhält. Die Metalle Kupfer und Indium werden dabei in einem Molverhältnis von 0,85 kleiner Cu/In kleiner 1,0 aufgebracht. Die nichtmetallische Komponente wird wegen ihrer Flüchtigkeit im stöchiometrischen Überschuß von 0 bis 100 %, typischerweise in einem Überschuß von 40 % darauf aufgedampft. Die Schichtdicken der Elementschichten können so variiert werden, daß die Absorberschicht eine Dicke von 1 bis 3 µm erreicht.

Der Schichtaufbau aus den elementaren Einzelschichten wird nun durch Tempern in einer inerten oder reaktiven Atmosphäre in den Verbindungshalbleiter der Absorberschicht überführt. Dazu kann ein schneller Temperprozeß durchgeführt werden. Zusätzlich kann dazu der Schichtaufbau verkapselt oder abgedeckt werden, so daß ein Abdampfen von flüchtigen Komponenten verhindert wird.

Eine weitere Möglichkeit zur Erzeugung des Schichtaufbaus als Vorstufe des Verbundhalbleiters besteht darin, zwei der Komponenten als binäre Verbindungen über dem vorbereiteten Substrat abzuscheiden und die dritte Komponente als elementare Schicht aufzutragen. Geeignete Binärverbindungen sind die Selenide von Indium und Gallium.

In einer weiteren Variation des Verfahrens, in der eine homogenere Absorberschicht AS angestrebt wird, wird der Schichtaufbau für die spätere Absorberschicht in Form von mehr als drei Einzelschichten erzeugt, wobei sich die Schichtreihenfolge wiederholen kann.

Möglich ist es auch, den Verbundhalbleiter in einem einstufigen Prozeß durch gleichzeitiges Aufdampfen auf das vorgeheizte Substrat aufzubringen. Da die Reaktion zum Verbundhalbleiter bereits während der Abscheidung erfolgt, ist bei dieser Variante kein Temperprozeß erforderlich.

Nach dem Herstellen der Absorberschicht AS wird deren Haftung auf dem Substrat bzw. auf dem mit Rückelektrode RE und Zwischenschicht ZS versehenen Substrat geprüft. Dazu wird in einem Abziehtest ein Klebeband auf die Absorberschicht aufgeklebt und wieder abgezogen. Es zeigt sich, daß mit dem in Figur 1 dargestellten Aufbau unabhängig von der Herstellung der Absorberschicht AS eine deutlich verbesserte Haftung erreicht wird. Außerdem zeigt sich, daß bereits an diesem Punkt des Herstellungsverfahrens ein wesentlich höherer Prozentsatz völlig unbeschädigter bzw. voll funktionsfähiger Produkte erhalten wird (im Vergleich zu Proben, die ohne Zwischenschicht ZS hergestellt wurden).

### Zweites Ausführungsbeispiel:

Figur 1: In einer weiteren Variation des Verfahrens wird über dem Substrat S eine Rückelektrode RE aus Titan in einem geeigneten Dünnschichtverfahren aufgebracht. Darüber wird eine Zwischenschicht ZS aus Titannitrid erzeugt, im Ausführungsbeispiel durch Sputtern von Titan in einer stickstoffhaltigen Atmosphäre.

Der Aufbau der Absorberschicht AS kann wie im ersten Ausführungsbeispiel beschrieben mit einem beliebigen bekannten Verfahren aus einem Chalkopyrithalbleiter erzeugt werden.

Auch bei diesem Aufbau zeigt sich eine verbesserte Haftung der Absorberschicht AS über der Zwischenschicht ZS.

### Fertigstellung der Solarzellenstruktur:

Figur 2: Zur Fertigstellung der Solarzelle wird über der Absorberschicht AS nach bekannten Methoden eine n-leitende Fensterschicht FS erzeugt, beispielsweise eine 10 bis 50 nm dikke Cadmiumsulfidschicht.

Vervollständigt wird der Solarzellenaufbau durch eine transparente Frontelektrode FE, beispielsweise eine ca. 1 µm dicke Zinkoxidschicht, die gesputtert oder mit einem CVD-Verfahren abgeschieden werden kann. Möglich ist es auch, andere transparente Oxide zu verwenden.

Wahlweise kann zur besseren Stromableitung über der Frontelektrode FE noch eine Gridelektrode GE aufgebracht werden, beispielsweise durch Aufdampfen eines elektrisch leitfähigen Metalles wie beispielsweise Silber, Nickel, Kupfer oder ähnliches, oder durch Aufdrucken und Einbrennen einer leitfähigen Paste oder durch Aufbringen einer entsprechenden Struktur eines Leitlackes oder Leitklebers.

Mit so hergestellten Solarzellen werden bislang Wirkungsgrade von über 10 % und mittlere Wirkungsgrade von 9 % bezogen auf die gesamte Substratfläche von ca. 10 x 10 cm² erreicht.

## Patentansprüche

1. Solarzelle mit einem elektrisch nichtleitenden Substrat (S), einer Rückelektrode (RE) und mit einer Chalkopyritabsorberschicht der allgemeinen Zusammensetzung CuIn₁₋ₓGaₓS_{2-y}Se_{y} 0 ≤ x ≤ 1 , 0 ≤ y ≤ 2, bei der zwischen Absorberschicht (AS) und Rückelektrode eine Zwischenschicht (ZS) aus einem Material angeordnet ist, welches ausgewählt ist aus Cr, Ti, Ta und Titannitrid, und wobei die Zwischenschicht (ZS) eine Dicke von 1 - 40 mm besitzt.

2. Solarzelle nach Anspruch 1, bei der die Zwischenschicht (ZS) aus Titannitrid ist und über einer Rückelektrode (RE) aus Titan angeordnet ist.

3. Solarzelle nach Anspruch 1, bei der die Zwischenschicht (ZS) über einer Rückelektrode (RE) aus Molybdän angeordnet ist.

## Claims

1. Solar cell comprising an electrically insulating substrate (S), a back electrode (RE) and a chalcopyrite absorbent layer of the general composition CuIn₁₋ₓGaₓS_{2-y}Se_{y} (0≤x≤1, 0≤y≤2), an intermediate layer (ZS) being arranged between the absorbent layer (AS) and the back electrode, said intermediate layer being of a material selected from Cr, Ti, Ta and titanium nitride, said intermediate layer (ZS) having a thickness between 1-40 nm.

2. Solar cell according to claim 1 comprising an intermediate layer (ZS) made of titanium nitride, said layer being arranged above a back electrode (RE) made of titanium.

3. Solar cell according to claim 1, wherein the intermediate layer (ZS) is arranged above a back electrode (RE) made of molybdenum.

## Revendications

1. Cellule solaire avec substrat non conducteur de l'électricité (S), électrode de retour (RE) et couche absorbante de chalcopyrite de composition générale CuIn₁₋ₓGaₓS_{2-y}Se_{y} (0≤x≤1, 0≤y≤2), dans laquelle entre la couche absorbante (AS) et l'électrode de retour, une couche intermédiaire (ZS) en un certain matériau est agencée, laquelle est sélectionnée parmi les Cr, Ti, Ta et nitrure de titane, et dans laquelle la couche intermédiaire (ZS) présente une épaisseur de 1 à 40 nm.

2. Cellule solaire selon la revendication 1, dans laquelle la couche intermédiaire (ZS) est en nitrure de titane et est agencée sur une électrode de retour (RE) en titane.

3. Cellule solaire selon la revendication 1, dans laquelle la couche intermédiaire (ZS) est agencée sur une électrode de retour (RE) en molybdène.
